# EUROPÄISCHE PATENTSCHRIFT

(11) **EP 0 905 812 B1**
(45) Veröffentlichungstag und Bekanntmachung des Hinweises auf die Patenterteilung: **01.03.2006**
(21) Anmeldenummer: 98203149.4
(22) Anmeldetag: 21.09.1998
(51) Int. Cl.: H01P 1/04

(54) **HF-Modul**
HF Module
Module HF

(30) Priorität: 27.09.1997 DE 19742829
(43) Veröffentlichungstag der Anmeldung: 31.03.1999
(73) Patentinhaber: Skyware Radio Systems GmbH, 47809 Krefeld (DE)
(72) Erfinder: Matuschik, Peter, Dipl.-Ing., Röntgenstrasse 24, 22335 Hamburg (DE); Avramis, Evangelos, Dipl.-Ing., Röntgenstrasse 24, 22335 Hamburg (DE); Schiltmans, Ronald, Dipl.-Ing., Röntgenstrasse 24, 22335 Hamburg (DE)
(74) Vertreter: Kreutzer, Ulrich

(56) Entgegenhaltungen:
- US-A- 4 810 981
- US-A- 4 816 789
- US-A- 5 148 135

## Beschreibung

Die Erfindung bezieht sich auf ein HF-Modul mit einer Anordnung zur elektrischen Verbindung von mindestens zwei HF-Leiterbahnen, die auf nebeneinanderliegenden, durch einen Spalt getrennten Leiterplatten ausgebildet sind und deren Enden im Spaltbereich einander gegenüberliegen.

In der Hochfrequenztechnik kommt es häufig vor, daß zwei aus verschiedenen Rohmaterialien hergestellte Leiterplatten, die eine unterschiedliche Dielektrizitätskonstante ε_{R} besitzen, elektrisch miteinander verbunden werden müssen. Dazu werden in bekannter Weise die sich auf den Leiterplatten befindenden lokalen Leiterbahnen durch sogenanntes Bonden miteinander verbunden. Hierbei handelt es sich um eine Ultraschall-Schweißverbindung, bei welcher die beiden zu verbindenden Leiterbahnen der verschiedenen Leiterplatten durch sehr dünne Golddrähte miteinander verbunden werden. Ein derartiges Verfahren ist aufwendig, umständlich und kostenintensiv. Notwendig wird ein derartiges spezielles Schweißverfahren z.B. bei Leiterplatten, die für verschiedene Frequenzbereiche ausgebildet sind. Zur elektrischen Verbindung derartiger Leiterplatten sind herkömmliche Lötverbindungen nicht geeignet, da sie den Hochfrequenzbedingungen nicht genügen.

Aus der US 5,148,135 ist ein HF-Modul bekannt, bei dem eine einfache Anordnung zur elektrischen Verbindung solcher HF-Leiterbahnen durch eine den Spaltbereich überbrückende und gegen die Leiterplatten gepreßte Hilfsleiterplatte, die an ihrer Unterseite im Bereich der zu verbindenden HF-Leiterbahn mit Hilfskontakten versehen ist, geschaffen wird. Allerdings ist die bekannte Verbindung verhältnismäßig aufwendig in der Herstellung.

Davon ausgehend liegt der Erfindung die Aufgabe zugrunde, ein HF-Modul anzugeben, bei dem die Verbindung der HF-Leiterbahn auf besonders zuverlässige, einfache und leicht herstellbare Weise geschaffen werden kann.

Die Merkmale des Anspruches 1 ermöglichen eine zuverlässige, einfache und leicht herstellbare Verbindung zwischen den Leiterbahnen, die auf zwei Leiterplatten ausgebildet sind, die innerhalb eines zweiteiligen HF-Moduls lagefixiert angeordnet sind. Der Anpreßdruck wird dadurch erzeugt, daß an dem ohnehin vorhandenen Deckelteil im Bereich der zu verbindenden Leiterbahnen vorstehende Teile angeordnet sind, die beim mechanischen Verbinden des Boden- und Deckelteiles auf die Hilfsleiterplatte gepreßt werden, so daß die an ihrer Unterseite angeordneten Hilfsleiterbahnen die HF-Leiterbahnen der beiden Leiterplatten miteinander verbinden. Dabei muß gewährleistet sein, daß die auf der Rückseite der Hilfsleiterplatte angreifenden Teile des Deckelteiles so weit vorstehen, daß auch bei fest zusammengefügtem Boden- und Deckelteil ein ausreichender Andruck gewährleistet ist.

Die Merkmale des Anspruches 2 ermöglichen eine einfache Verbindung zwischen Deckel- und Bodenteil und ein zuverlässiges Andrücken der vorstehenden Teile des Deckelteiles gegen die Rückseite der Hilfsleiterplatte.

Die Merkmale des Anspruches 3 gewährleisten eine absolut zuverlässige gegenseitige Zuordnung zwischen den beiden Gehäuseteilen einerseits und den Leiterplatten und der Hilfsleiterplatte andererseits. Dabei sind die Stifte vorzugsweise im Gehäuseunterteil angebracht. Dies bedeutet, daß bei der Montage zunächst die beiden Leiterplatten auf das Gehäuseunterteil aufgesetzt werden und daß danach die Hilfsleiterplatte, von entsprechenden Stiften geführt, auf den Spaltbereich der beiden mit Abstand einander gegenüberliegenden Leiterplatten gesetzt wird. Danach erfolgt das Aufsetzen des Gehäuseoberteils und danach das Verbinden der beiden Gehäuseteile, welches vorzugsweise gemäß Anspruch 3 durch Schrauben erfolgt.

Durch die Merkmale des Anspruches 4 wird erreicht, daß der Andruck jeweils gezielt nur im Bereich der miteinander elektrisch zu verbindenden Leiterbahnen ausgeübt wird.

Eine besonders sichere Ausführung zur Erzielung einer zuverlässigen HF-Verbindung zwischen zwei einander gegenüberliegenden. HF-Leiterbahnen wird durch die Merkmale des Anspruches 5 erzielt. Dabei erfolgt ein Andruck im wesentlichen nur jeweils im Bereich der beiden Enden der auf der Hilfsleiterplatte angeordneten Hilfsleiterbrücken.

Durch die Merkmale des Anspruches 6 wird ein Verkanten beim Zusammenpressesn der beiden Gehäuseteile vermieden.

Durch die Merkmale des Anspruches 7 können Leiterplatten unterschiedlicher Dicke auf einfache Weise so angeordnet werden, daß die miteinander zu verbindenden Leiterbahnen der beiden Leiterplatten in einer Ebene liegen.

In der Zeichnung ist in den Fig. 1 bis 4 ein Ausführungsbeispiel des Gegenstandes gemäß der Erfindung schematisch dargestellt.
Fig. 1 zeigt einen Querschnitt durch ein zweiteiliges HF-Modul mit einem Unterteil und einem Oberteil,
Fig. 2 zeigt eine Draufsicht auf die Innenseite des Modul-Unterteiles mit eingelegten Leiterplatten,
Fig. 3 zeigt eine Draufsicht auf die Innenseite des Gehäuse-Deckelteiles, und
Fig. 4 zeigt eine Draufsicht auf eine Hilfsleiterplatte.

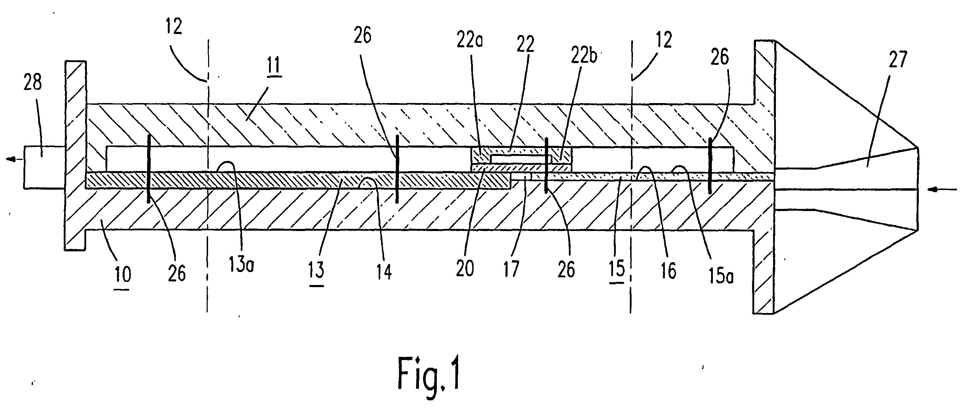

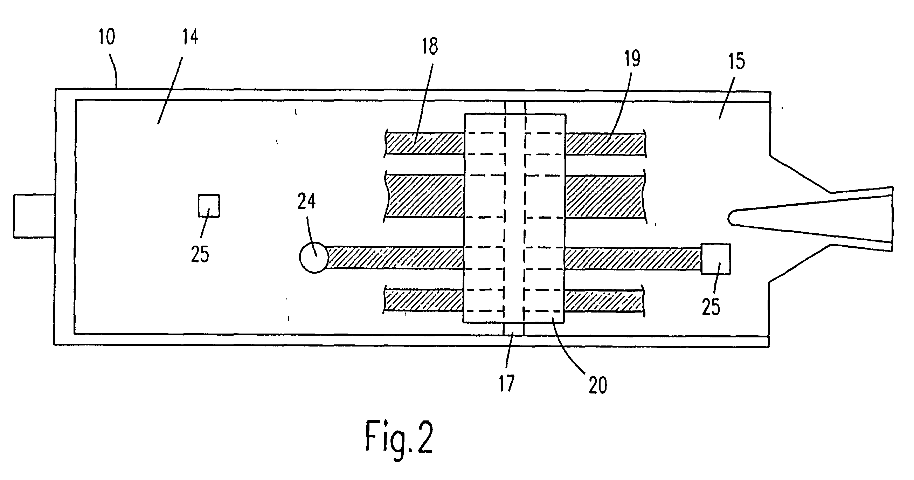

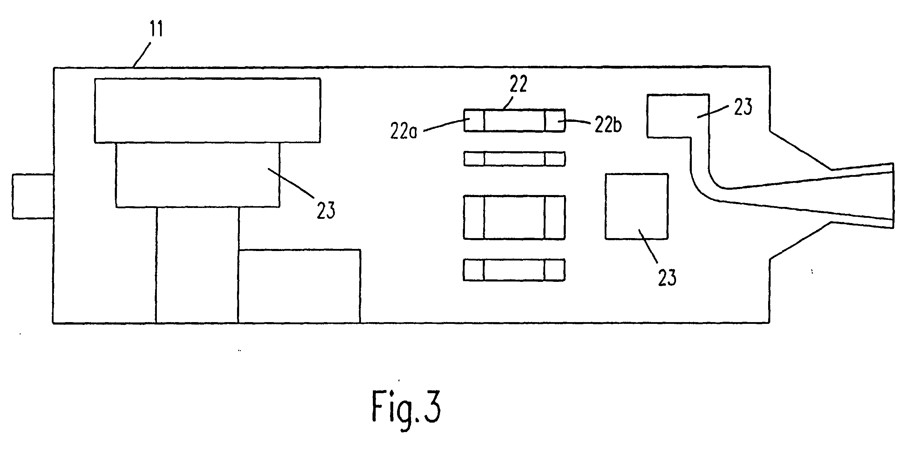

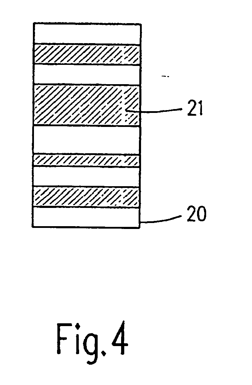

Gemäß Fig. 1 bis 4 besitzt das HF-Modul ein Gehäuse mit einem Unterteil 10 und einem Deckelteil 11, die durch Schrauben 12 fest miteinander verbunden sind. Zwischen den beiden Gehäuseteilen 10 und 11 befinden sich zwei unterschiedlich dicke Leiterplatten, und zwar eine erste Leiterplatte 13, die in einer Vertiefung 14 des Unterteiles 10 liegt, und eine zweite Leiterplatte 15, die auf einer Erhöhung 16 des Unterteiles 10 liegt. Die Dicken der beiden Leiterplatten 13, 15 und die Vertiefung 14 bzw. Erhöhung 16 sind derart aufeinander abgestimmt, daß die Oberflächen 13a, 15a beider Leiterplatten in einer Ebene liegen. Beide Leiterplatten sind durch einen Spalt 17 voneinander getrennt und besitzen HF-Leiterbahnen 18, 19. die im Bereich des Spaltes 17 einander gegenüberliegen und durch eine den Spaltbereich überdeckende Hilfsleiterplatte 20 elektrisch leitend miteinander verbunden werden. Zur elektrischen Verbindung dienen auf der Unterseite der Hilfsleiterplatte 20 angeordnete Hilfsleiterbahnen 21, die bei aufgesetzter und angedrückter Hilfsleiterplatte 20 die Enden der einander gegenüberliegenden Leiterbahnen 18, 19 HF-mäßig miteinander verbinden.

Die elektrische Verbindung der Leiterbahnen 18, 19 erfolgt dadurch, daß die Hilfsleiterplatte 20 durch vorstehende Teile 22 des Deckelteiles 11 beim Zusammenschrauben beider Gehäuseteile 10 und 11 gegen die Endbereiche der beiden Leiterplatten 13, 14 gedrückt wird. Dadurch legen sich die Hilfsleiterbahnen 21 auf die mit Abstand einander gegenüberliegenden Leiterbahnen 18, 19 und gewährleisten eine zuverlässige HF-Verbindung. Die vorstehenden Teile 22 des Deckelteiles 11 sind einerseits jeweils als diskrete Elemente im Bereich zweier einander gegenüberliegender Leiterbahnen angeordnet und besitzen andererseits eine Jochform mit zwei Schenkeln 22a und 22b. Die beiden Schenkel 22a, b drücken jeweils nur in den Endbereichen der Hilfsleiterbahnen 21, so daß Verkantungen zuverlässig vermieden werden. Um sicherzugehen, daß ein ausreichender Druck ausgeübt wird, kann oberhalb der Hilfsleiterplatte 20 noch mindestens eine weitere, nicht dargestellte Zwischenlage als Leiterplatte vorgesehen sein.

Ein derartiges HF-Gehäuse ist z.B. ein HF-Modul, dessen Deckelteil 11 auf seiner Innenseite mit Kammern 23 versehen ist, die mit Bauelementen 24, 25 auf den Leiterplatten 13, 15 HF-Kreise bilden. Das Bodenteil 10 ist mit Stiften 26 versehen, die Bohrungen der Leiterplatten 13, 15 und der Hilfsleiterplatte 20 durchdringen und zumindest teilweise zur Lagefixierung in Bohrungen des Deckelteiles münden. Mit 27 ist ein Eingang und mit 28 ein Ausgang für eine Antennenspannung bezeichnet. Ein derartiges HF-Modul wird z.B. verwendet in Satelliten-Empfangsanlagen, die unter dem Namen LNB (Low Noise Block) bzw. MVDS (Microwave Video Distribution System) bekanntgeworden sind.

## Patentansprüche

1. HF-Modul mit einer Anordnung zur elektrischen Verbindung von mindestens zwei HF-Leiterbahnen (18, 19), die auf nebeneinanderliegenden, durch einen Spalt (17) getrennten Leiterplatten (13.15) ausgebildet sind und deren Enden im Spaltbereich einander gegenüberliegen, wobei eine den Spaltbereich überbrückende und gegen die Leiterplatten (13, 15) gepreßte Hilfsleiterplatte (20) vorgesehen ist die an ihrer Unterseite im Bereich der zu verbindenden HF-Leiterbahnen (18, 19) mit Hilfskontaktbrücken (21) versehen ist,
**dadurch gekennzeichnet,**
- **daß** die Leiterplatten (13, 15) und die Hilfsleiterplatte (20) auf dem Unterteil (10) eines zweiteiligen HF-Gehäuses lagefixiert sind, dessen Deckelteil (11) mit auf den Leiterplatten (13, 15) angeordneten Bauelementen (24, 25) HF-Schaltkreise bildet, und
- **daß** der Anpreßdruck auf die Hilfsleiterplatte (20) durch vorstehende Teile (22) des mit dem Unterteil (10) fest verbundenen Deckelteiles (11) erfolgt.

2. HF-Modul nach Anspruch 1, **dadurch gekennzeichnet, daß** Boden- und Deckelteil (10, 11) durch Schrauben (12) miteinander verbunden sind.

3. HF-Modul nach Anspruch 1 oder 2, **dadurch gekennzeichnet, daß** die beiden Gehäuseteile (10, 11) zusammen mit den Leiterplatten (13, 15) und der Hilfsleiterplatte (20) durch Stifte (26) zentriert sind.

4. HF-Modul nach einem der Ansprüche 1 bis 3, **dadurch gekennzeichnet, daß** die vorstehenden Teile (22) als diskrete Erhebungen gesondert in jedem Bereich von zwei zu verbindenden HF-Leiterbahnen (18, 19) ausgebildet sind.

5. HF-Modul nach Anspruch 4, **dadurch gekennzeichnet, daß** die vorstehenden Teile (22) jochförmig ausgebildet und mit zwei U-förmigen Schenkeln (22a, b) versehen sind, die im fest verbundenen Zustand der beiden Gehäuseteile den Spalt (17) überbrücken und mit ihren Enden über die Hilfsleiterplatte (20) auf das jeweilige Ende der zu verbindenden Leiterbahnen (18, 19) gepreßt sind.

6. HF-Modul nach Anspruch 1, **dadurch gekennzeichnet, daß** die Oberseiten (13a. 15a) der HF-Leiterplatten (13, 15) in einer Ebene liegen.

7. HF-Modul nach Anspruch 6, **dadurch gekennzeichnet, daß** das Unterteil (10) des Gehäuses zur Aufnahme verschieden dicker Leiterplatten (13,15) stufig (14, 16) ausgebildet ist.

## Claims

1. HF module with an arrangement for electrically interconnecting at least to HF conductor tracks (18, 19), which are formed on adjacent printed circuit boards (13, 15) being separated by a slit (17) and the ends of which are situated opposite each other in the region of said slit, wherein an auxiliary printed circuit board (20) bridging said region of said slit and being pressed against said printed circuit board (13, 15) and having on its lower side in the region of said HF conductor tracks (18, 19), which are to be interconnected, auxiliary conductor tracks (21),
**characterized in**
- **that** said circuit boards (13, 15) and said auxiliary circuit board (20) are locationally fixed on the bottom part (10) of a two-part HF housing, whose cover part (11) constitutes with components (24, 25) arranged on said circuit boards (13, 15) HF circuits; and
- **that** said contact pressure is applied to the auxiliary circuit board (20) by protuberant portions (22) of said cover part (11), which is rigidly connected with said bottom part (10).

2. HF module according to claim 1, **characterized in that** that said bottom part (10) and said cover part (11) are interconnected by screws (12).

3. HF module according to claim 1 or 2, **characterized in that** both housing parts (10, 11) are centred together with said circuit boards (13, 15) and said auxiliary circuit board (20) by means of pins (26).

4. HF module according to one of the claims 1 to 3, **characterized in that** said protuberant parts (22) are separately embodied so as to be discrete raised portions present in each region of two HF conductor tracks (18, 19) to be interconnected.

5. HF module according to claim 4, **characterized in that** said protuberant parts (22) are embodied so as to be yoke-shaped and are provided with two U-shaped limbs (22a, b) which, in the rigidly interconnected state of said two both housing parts, bridge said slit (17) and are pressed with their ends via said auxiliary printed circuit board (20) on the corresponding end of the conductor tracks to be interconnected (18, 19).

6. HF module according to claim 1, **characterized in that** the upper sides (13a, 15a) of said HF circuit boards (13, 15) extend in one plane.

7. HF module according to claim 6, **characterized in that** the lower part (10) of said housing is of a stepped construction for accommodating circuit boards (13, 15) of different thickness.

## Revendications

1. Module H.F. ayant une disposition pour la connexion électrique d'au moins deux pistes conductrices H.F. (18, 19) qui sont réalisées sur des cartes de circuits imprimés (13, 15) situées l'une à côté de l'autre et séparées par une fente (17), et dont les extrémités sont placées en vis-à-vis dans la zone de la fente, une carte auxiliaire de circuits imprimés (20) étant prévue qui recouvre la zone de la fente et est plaquée contre les cartes de circuits imprimés (13, 15) et dont la face inférieure est munie, au niveau des pistes conductrices H.F. (18, 19) à connecter, de ponts auxiliaires de contact (21),
**caractérisé par le fait**
- **que** les cartes de circuits imprimés (13,15) et la carte auxiliaire de circuits imprimés (20) sont fixées en position sur la partie inférieure (10) d'un boîtier H.F. en deux parties, dont la partie couvercle (11) forme avec des composants (24, 25) disposés sur les cartes de circuits imprimés (13, 15) des circuits H.F., et
- **que** la pression d'appui exercée sur la carte auxiliaire de circuits imprimés (20) est générée par des pièces en saillie (22) de la partie couvercle (11) solidaire de la partie inférieure (10).

2. Module H.F. selon la revendication 1, **caractérisé par le fait que** la partie de fond et la partie couvercle (10, 11) sont reliées entre elles par l'intermédiaire de vis (12).

3. Module H.F. selon la revendication 1 ou 2, **caractérisé par le fait que** les deux parties (10, 11) du boîtier conjointement avec les cartes de circuits imprimés (13, 15) et la carte auxiliaire de circuits imprimés (20) sont centrées au moyen de broches (26).

4. Module H.F. selon l'une des revendications 1 à 3, **caractérisé par le fait que** lesdites pièces en saillie (22) sont réalisées comme élévations discrètes de manière séparée dans chaque zone de deux pistes conductrices H.F. (18, 19) à connecter.

5. Module H.F. selon la revendication 4, **caractérisé par le fait que** lesdites pièces en saillie (22) sont réalisées en forme de joug et sont pourvues de deux branches en U (22a,b) qui, lorsque les deux parties du boîtier sont reliées solidement, recouvrent ladite fente (17) et sont plaquées avec leurs extrémités, par ladite carte auxiliaire de circuits imprimés (20), contre l'extrémité respective des pistes conductrices (18, 19) à connecter.

6. Module H.F. selon la revendication 1, **caractérisé par le fait que** les faces supérieures (13a, 15a) des cartes H.F. de circuits imprimés (13, 15) sont situées dans un plan.

7. Module H.F. selon la revendication 6, **caractérisé par le fait que** la partie inférieure (10) du boîtier est réalisée à gradins (14, 16) pour recevoir des cartes de circuits imprimés (13, 15) présentant des épaisseurs différentes.
